(19) Europäisches Patentamt
European Patent Office
Office européen des brevets

(11) EP 2 117 094 B1

(12) EUROPÄISCHE PATENTSCHRIFT

(45) Veröffentlichungstag und Bekanntmachung des Hinweises auf die Patenterteilung:
24.08.2022 Patentblatt 2022/34

(21) Anmeldenummer: 09005080.8

(22) Anmeldetag: 07.04.2009

(51) Internationale Patentklassifikation (IPC):
H02H 3/04 (2006.01)   H02H 3/20 (2006.01)
G01R 19/165 (2006.01)   G01R 35/00 (2006.01)

(52) Gemeinsame Patentklassifikation (CPC):
H02H 3/044; G01R 19/1659; H02H 3/207;
G01R 19/16552; G01R 35/00

(54) **Überwachungsschaltung und Verfahren zum Prüfen der Schaltung**

Monitoring switch and method for checking the switch

Commutation de surveillance et procédé de contrôle d'une commutation

(84) Benannte Vertragsstaaten:
AT BE BG CH CY CZ DE DK EE ES FI FR GB GR HR HU IE IS IT LI LT LU LV MC MK MT NL NO PL PT RO SE SI SK TR

(30) Priorität: 11.04.2008 DE 102008018642

(43) Veröffentlichungstag der Anmeldung:
11.11.2009 Patentblatt 2009/46

(73) Patentinhaber: Eaton Intelligent Power Limited
Dublin 4 (IE)

(72) Erfinder: Culca, Horea-Stefan
53797 Lohmar (DE)

(74) Vertreter: Schneider, Gregor
Eaton IP Group EMEA
Route de la Longeraie 7
1110 Morges (CH)

(56) Entgegenhaltungen:
DE-T2- 69 811 950      DE-U1- 29 721 675
JP-A- S5 725 012       JP-A- H08 294 226
US-A1- 2003 007 300

**Beschreibung**

**Technisches Gebiet**

Die Erfindung bezieht sich auf die Überwachung einer Spannung. Insbesondere betrifft die Erfindung eine Schaltungsanordnung zum Überwachen einer Spannung sowie ein Verfahren zum Überprüfen einer Schaltungsanordnung.

**Hintergrund der Erfindung**

Die Versorgungsspannung bestimmter elektronischer Geräte, wie beispielsweise Mikrocontroller, darf nur eine relativ geringe Abweichung von einem Sollwert aufweisen, um die korrekte Funktion der Geräte sicherzustellen. Daher werden oftmals Überwachungsschaltungen eingesetzt, die überprüfen, ob die Spannung in einem vorgegebenen Intervall um den Sollwert liegt. Bei einer Unter- oder Überspannung werden die Geräte mittels der Überwachungsschaltung in einen sicheren Zustand versetzt. In der Regel bedeutet dies, dass die Geräte beziehungsweise von den Geräten gesteuerte Ausgänge abgeschaltet werden.

Eine Überwachungsschaltung ist in der Regel ein zentraler Bestandteil der Beschaltung von Steuerungseinrichtungen mit sicherheitskritischen Steuerungsaufgaben. Sie dient beispielsweise dazu, Schäden zu vermeiden, die durch eine fehlerhafte Steuerung aufgrund einer zu geringen oder zu hohen Versorgungsspannung verursacht werden könnten. Um eine zuverlässige Spannungsüberwachung zu gewährleisten, muss sichergestellt werden, dass die Überwachungsschaltung selbst störungsfrei arbeitet.

Aus der EP 1 042 679 A1 geht eine Überwachungsschaltung für eine elektrische Spannung hervor, bei der Störungen der Überwachungsschaltung in einem Eigentestmodus erfasst werden. Die Schaltung umfasst zwei Komparatoren, die jeweils ein unteres und ein oberes mittels eines Spannungsteilers aus der zu überwachenden Spannung abgeleitetes Potenzial mit einem Referenzpotenzial vergleichen. Eine Unterspannung wird festgestellt, wenn das untere Potenzial das Referenzpotenzial unterschreitet, und eine Überspannung wird festgestellt, wenn das obere Potenzial das Referenzpotenzial überschreitet. Im Eigentestmodus wird an einen Komparator anstelle des oberen Potenzials eine über einem Grenzwert liegende Speisespannung angelegt, um eine Überspannung zu simulieren. Zudem wird der andere Komparator anstelle des unteren Potenzials mit Massepotenzial verbunden, um eine Unterspannung zu simulieren.

Bei der Überwachungsschaltung wird eine Unterspannung unter Verwendung des Massepotenzials simuliert, was in der Regel einer sehr großen Abweichung vom unteren Spannungsgrenzwert entspricht. Sehr große Abweichungen kommen jedoch selten vor. Häufig sind es wesentlich geringere Unterspannungen, bei denen der Fehlerfall ausgelöst werden muss. Bei der Simulation der Überspannung besteht das Problem, dass die Speisespannung entweder sehr groß gewählt werden muss, um eine Überspannung zuverlässig zu simulieren, so dass nur der Fall einer sehr hohen Überspannung getestet wird, oder dass die Speisespannung relativ genau auf einen geringeren Wert eingestellt werden muss, was mit einem hohen zusätzlichen Aufwand verbunden ist. Ferner besteht das Problem, dass die Eingangsstufe der Überwachungsschaltung, an der die zu überwachende Spannung anliegt, im Eigentestmodus umgangen wird und daher nicht auf Fehler getestet werden kann.

Die DE 101 27 054 A1 beschreibt eine Spannungsüberwachung, bei der eine Versorgungsspannung mit einem oberen und einem unteren Grenzwert verglichen wird. Hierzu wird eine Komparatorschaltung verwendet, der Spannungen zugeführt werden, die mittels eines Spannungsteilers aus der Versorgungsspannung abgeleitet werden. Diese Spannungen werden von der Komparatorschaltung jeweils mit einer Referenzspannung verglichen. Um die Spannungsüberwachung zu testen, werden die Grenzwerte verzogen, so dass ein Fehler angezeigt wird.

Aus der DE 101 42 011 A2 geht eine Komparatorschaltung zum Überwachen einer Versorgungsspannung auf eine untere und eine obere Grenze hervor. Durch einen Spannungsteiler werden aus der Versorgungsspannung Teilspannungen gewonnen, die mit einer Referenzspannung verglichen werden. Eine Veränderung der Grenzwerte kann durch Integration von Widerständen in dem Spannungsteiler vorgenommen werden.

Die DE 199 27 389 A1 beschreibt eine Schaltung zum Detektieren eines unzulässig hohen Stroms in einer Brückenschaltung mit zwei Transistoren. Hierzu wird die am Verbindungspunkt der Transistoren auftretende Spannung mit einer Vergleichsspannung verglichen. Diese wird an einem Spannungsteiler abgegriffen und kann dadurch verändert werden, dass ein Widerstand innerhalb des Spannungsteilers zugeschaltet wird.

**Zusammenfassung der Erfindung**

Es ist eine Aufgabe der vorliegenden Erfindung, eine realistischere Simulation einer Fehlspannung bei einer Schaltung zum Überwachen einer Spannung zu ermöglichen.

Die Aufgabe wird durch eine Schaltungsanordnung mit den Merkmalen des Patentanspruchs 1 und durch ein Verfahren mit den Merkmalen des Patentanspruchs 10 gelöst. Ausführungsformen der Schaltungsanordnung und des Verfahrens sind in den abhängigen Ansprüchen angegeben.

Ein Vorteil der Erfindung besteht darin, dass eine Fehlspannung, d.h. eine Überspannung, bei der die zu überwachende Spannung über einem Grenzwert liegt, oder eine Unterspannung, bei der die zu überwachende Spannung unter einem Grenzwert liegt, durch die Veränderung eines Widerstandes innerhalb des Spannungsteilers simuliert werden kann. Insbesondere wird das mit dem Referenzpotenzial zu vergleichende, aus der zu überwachenden Spannung abgeleitete Potenzial oder das Referenzpotenzial derart verändert, dass eine Über- bzw. Unterspannung detektiert wird, wenn die Schaltungsanordnung störungsfrei arbeitet. Dabei ist zur Simulation von Fehlspannungen insbesondere keine Zuschaltung einer weiteren Spannungsquelle erforderlich. Hierdurch wird die Simulation realistischer und kann einfacher durchgeführt werden.

Ferner ermöglicht es die Erfindung, durch eine geeignet gewählte Veränderung des Widerstands innerhalb des Spannungsteilers auch geringe Fehlspannungen zu simulieren. Hierdurch kann geprüft werden, ob bereits eine geringe Fehlspannung gemeldet wird, was zu einer größeren Sicherheit bei der Spannungsüberwachung und zu einer noch realistischeren Simulation einer Fehlspannung führt.

Gemäß der Erfindung ist vorgesehen, dass der Widerstand innerhalb des Spannungsteilers dadurch veränderbar ist, dass ein elektrisch parallel zu einem Widerstand des Spannungsteilers geschalteter Strompfad, der einen weiteren Widerstand umfasst, durch ein Schaltelement geschlossen wird.

Ein Vorteil dieser Ausgestaltung besteht darin, dass der Widerstand innerhalb des Spannungsteilers besonders einfach verändert werden kann, da lediglich ein Strompfad mit einem Schaltelement und einem Widerstand benötigt wird. Hierbei handelt es sich zudem um unproblematische Bauteile, so dass die Schaltung mit hoher Zuverlässigkeit arbeitet und einfach realisiert werden kann.

Ferner genügt jeweils ein einziges Schaltelement zur Simulation einer Unter- bzw. Überspannung, wodurch Schaltelemente gegenüber der eingangs beschriebenen Schaltungsanordnung eingespart werden können.

In einer alternativen Ausgestaltung der Schaltungsanordnungen und des Verfahrens , die, jedoch, kein Teil der Erfindung ist, umfasst der Spannungsteiler wenigstens drei in Reihe geschaltete Widerstände, und der Widerstand innerhalb des Spannungsteilers ist dadurch veränderbar, dass wenigstens ein Widerstand des Spannungsteilers mittels eines Schaltelements überbrückt wird.

Diese Ausgestaltung weist ebenfalls die zuvor genannten Vorteile auf. Die Überbrückung kann beispielsweise dadurch erfolgen, dass ein parallel zu dem Widerstand geschalteter Strompfad mittels des Schaltelements geschlossen wird.

Die vorgeschlagene Schaltungsanordnung eignet sich zum Überwachen, ob die Spannung zwischen zwei vorgegebenen Grenzwerten, d.h., in einem vorgegeben Intervall, liegt.

Gemäß der Erfindung sind mit der Komparatorschaltung zwei von der zu überwachenden Spannung abgeleitete Potenziale mit einem Referenzpotenzial vergleichbar, um zu Überwachen, ob die Spannung zwischen zwei Grenzwerten liegt, wobei die von der zu überwachenden Spannung abgeleiteten Potenziale jeweils an einem Spannungsteiler abgegriffen werden, der eine Reihenschaltung aus wenigstens zwei Widerständen umfasst, und wobei innerhalb jedes der Spannungsteiler ein Widerstand derart veränderbar ist, dass eine Fehlspannung simuliert werden kann.

Eine derartige Konfiguration der Schaltungsanordnung erlaubt eine besonders einfache Überprüfung, ob die zu überwachende Spannung zwischen zwei Grenzwerten, insbesondere zwischen einem unteren und einem oberen Grenzwert liegt.

Eine Ausführungsform der Schaltungsanordnung und des Verfahrens beinhaltet, dass ein unteres von der zu überwachenden Spannung abgeleitetes Potenzial an einem ersten Spannungsteiler abgreifbar ist und mit dem Referenzpotenzial vergleichbar ist, um zu prüfen, ob eine Unterspannung vorliegt, bei der das untere Potenzial kleiner als das Referenzpotenzial ist.

Bei einer verbundenen Ausführungsform der Schaltungsanordnung und des Verfahrens ist vorgesehen, dass der Widerstand des ersten Spannungsteilers derart veränderbar ist, dass das untere Potenzial auch dann kleiner als das Referenzpotenzial ist, wenn die zu überwachende Spannung zwischen den Grenzwerten liegt.

Die zuvor genannten Ausführungsformen haben den Vorteil, dass eine Unterspannung als Unterfall einer Fehlspannung gezielt festgestellt und simuliert werden kann.

Bei der Simulation einer Unterspannung wird das untere Potenzial durch eine geeignete Veränderung des Widerstands des ersten Spannungsteilers so eingestellt, dass es auch dann kleiner als das Referenzpotenzial ist, wenn die zu überwachende Spannung zwischen den Grenzwerten liegt. Hierdurch wird sichergestellt, dass eine Unterspannung unabhängig von dem vorliegenden Wert der zu überwachenden Spannung simuliert werden kann.

Eine weitere Ausgestaltung der Schaltungsanordnung und des Verfahrens zeichnet sich dadurch aus, dass ein oberes von der zu überwachenden Spannung abgeleitetes Potenzial an einem zweiten Spannungsteiler abgreifbar ist und mit dem Referenzpotenzial vergleichbar ist, um zu prüfen, ob eine Überspannung vorliegt, bei der das obere Potenzial größer als das Referenzpotenzial ist.

Eine verbundene Ausgestaltung der Schaltungsanordnung und des Verfahrens ist dadurch gekennzeichnet, dass der Widerstand des zweiten Spannungsteilers derart veränderbar ist, dass das obere Potenzial auch dann kleiner als das Referenzpotenzial ist, wenn die zu überwachende Spannung zwischen den Grenzwerten liegt.

Die zuvor genannten Ausführungsformen haben den Vorteil, dass eine Überspannung als ein weiterer Unterfall einer Fehlspannung gezielt festgestellt und simuliert werden kann.

Bei der Simulation einer Überspannung wird das untere Potenzial durch eine geeignete Veränderung des Widerstands des ersten Spannungsteilers so eingestellt, dass es auch dann größer als das Referenzpotenzial ist, wenn die zu überwachende Spannung zwischen den Grenzwerten liegt. Hierdurch wird sichergestellt, dass eine Überspannung unabhängig von dem vorliegenden Wert der zu überwachenden Spannung simuliert werden kann.

Bei einer Weiterbildung der Schaltungsanordnung und des Verfahrens ist vorgesehen, dass im Falle einer Fehlspannung über einen Ausgang der Komparatorschaltung ein erstes Steuerschaltelement in einem Steuerstromkreis ansteuerbar ist, mit dem eine Energieversorgung zum Steuern eines Ausgangs eines Steuergeräts unterbrochen werden kann, und wobei ein Abgriff vorgesehen ist, an dem eine Unterbrechung der Energieversorgung bei Simulation einer Fehlspannung erfassbar ist.

Diese Weiterbildung weist die Besonderheit auf, dass bei der Simulation einer Fehlspannung eine Energieversorgung für ein Steuerschaltelement zum Schalten eines Ausgangs eines Steuergeräts erfassbar ist, die im Falle einer Fehlspannung beeinflusst werden soll. Insbesondere ist die Energieversorgung im Falle einer Fehlspannung abschaltbar, so dass der Ausgang des Steuergeräts ebenfalls abgeschaltet und damit in einen sicheren Zustand gebracht wird. Bei dieser Weiterbildung besteht der Vorteil, dass bei der Simulation der Fehlspannung nicht nur die Überwachungs- beziehungsweise Komparatorschaltung allein getestet wird, sondern auch die korrekte Funktion nachgeschalteter Elemente.

Eine weitere Ausgestaltung der Schaltungsanordnung und des Verfahrens zeichnet sich dadurch aus, dass im Falle einer Fehlspannung über einen Ausgang der Komparatorschaltung ein erstes Steuerschaltelement in einem Steuerstromkreis eines Relais abschaltbar ist, wobei mit dem Relais ein erster Ausgang eines Steuergeräts schaltbar ist, und dass der Steuerstromkreis mit einer Messeinrichtung verbunden ist, mit der ein Steuerstrom des Relais bei Simulation einer Fehlspannung erfassbar ist.

Bei dieser Ausgestaltung ist bei der Simulation einer Fehlspannung der Steuerstrom des Relais erfassbar ist, der im Falle einer Fehlspannung beeinflusst werden soll. Insbesondere ist der Steuerstrom des Relais bei einer Fehlspannung abschaltbar, so dass der von dem Relais geschaltete Ausgang des Steuergeräts ebenfalls abgeschaltet und damit in einen sicheren Zustand gebracht wird.

Zudem ist bei einer Ausgestaltung der Schaltungsanordnung und des Verfahrens vorgesehen, dass im Falle einer Fehlspannung über einen Ausgang der Komparatorschaltung ein zweites Steuerschaltelement zur Ansteuerung eines Halbleiterschalters abschaltbar ist, mit dem eine Versorgungsspannung zur Steuerung eines zweiten Ausgangs des Steuergeräts steuerbar ist, und dass ein Abgriff vorgesehen ist, an dem die Steuerspannung bei der Simulation einer Fehlspannung erfassbar ist.

Bei dieser Ausgestaltung ist ein Halbleiterschalter, beispielsweise ein Transistor, vorgesehen, um eine Spannung zur Steuerung eines Ausgangs des Steuergeräts zu steuern. Bei einer Fehlspannung wird die Spannungsversorgung zur Steuerung des Ausgangs insbesondere abgeschaltet, so dass der Ausgang abgeschaltet und damit in einen sicheren Zustand gebracht wird. Bei der Simulation einer Fehlspannung wird in der zuvor genannten Ausführungsform die Steuerspannung des Ausgangs erfasst. Hierdurch kann gleichfalls sichergestellt werden, dass über die Überwachungs- beziehungsweise Komparatorschaltung hinaus weitere Bauteile geprüft werden können.

Der Steuerstrom des Relais beziehungsweise die Steuerspannung des Ausgangs wird beispielsweise mittels eines Mikrocontrollers des Steuergeräts ausgewertet, um zu prüfen, ob das Relais beziehungsweise der Ausgang bei der Simulation einer Fehlspannung in einen sicheren Zustand geschaltet wird. Ist dies nicht der Fall, wird eine Störung der Schaltungsanordnung festgestellt.

Eine weitere Ausgestaltung der Schaltungsanordnung und des Verfahrens beinhaltet, dass die Komparatorschaltung zwei Komparatoren umfasst, welche Open-Collector-Ausgänge aufweisen, welche in einer Open-Collector-Schaltung verknüpft sind, die eine Ausgangsspannung der Komparatorschaltung erzeugt.

Anhand der Open-Collector-Schaltung ist eine besonders einfache Verknüpfung der Komparatorausgänge möglich. Innerhalb der Open-Collector-Schaltung sind die Open-Collector-Ausgänge der Komparatoren mit einem Ausgang der Komparatorschaltung sowie über einen Widerstand mit einem Potenzial verbunden.

Die zuvor genannten und weitere Vorteile, Besonderheiten und zweckmäßige Weiterbildungen der Erfindung werden auch anhand der Ausführungsbeispiele deutlich, die nachfolgend unter Bezugnahme auf die Figuren beschrieben werden.

## Kurze Beschreibung der Figuren

Von den Figuren zeigt:

Fig. 1    ein schematisches Schaltbild einer Überwachungsschaltung nach der Erfindung und

Fig. 2    ein schematisches Schaltbild zur Veranschaulichung eines Einsatzes der in Figur 1 dargestellten Überwachungsschaltung in einem Steuergerät.

**Ausführliche Darstellung von Ausführungsbeispielen**

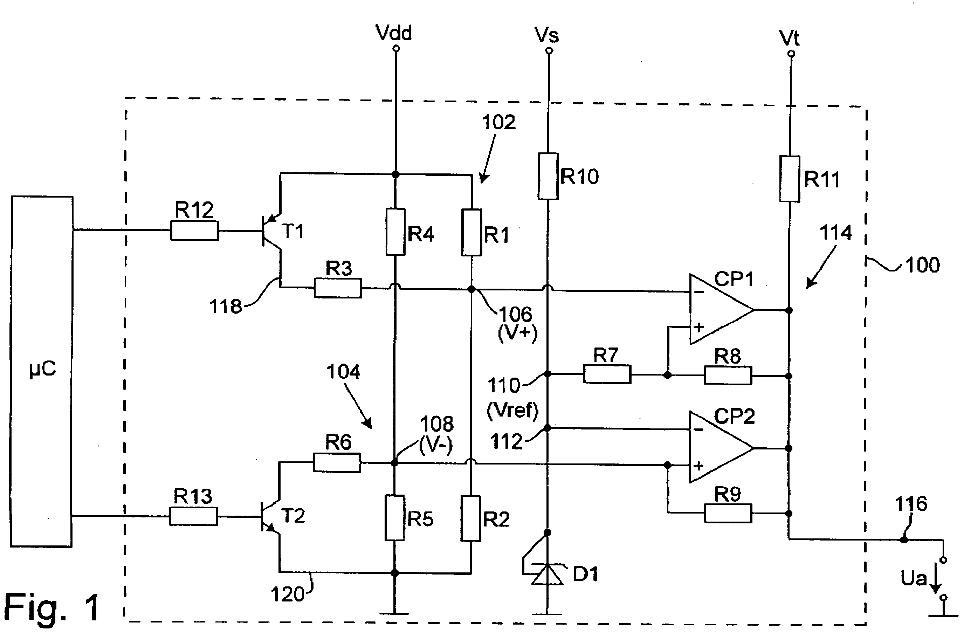

In Figur 1 ist eine Überwachungsschaltung 100 zum Überwachen einer Spannung Vdd mittels einer Komparatorschaltung dargestellt.

Die Spannung Vdd liegt über einem ersten Spannungsteiler 102 an, der durch eine Reihenschaltung der Widerstände R1 und R2 gebildet wird, und wird an dem Spannungsteiler 102 derart geteilt, dass an einem Abgriff 106 zwischen den beiden Widerständen R1, R2 das elektrische Potenzial V+ vorliegt.

Elektrisch parallel zu dem ersten Spannungsteiler 102 ist ein zweiter Spannungsteiler 104 geschaltet, der eine Reihenschaltung der Widerstände R4 und R5 umfasst. An dem Spannungsteiler 104 wird die Spannung Vdd so geteilt, dass an einem Abgriff 108 zwischen den Widerständen R4, R5 das elektrische Potenzial den Wert V- annimmt.

Die Komparatorschaltung umfasst zwei Komparatoren CP1 und CP2, deren Ausgänge die Zustände "high" und "low" annehmen können und die nach Art eines Fensterkomparators geschaltet sind. Dabei ist der invertierende Eingang des Komparators CP1 mit dem Abgriff 106 des Spannungsteilers 102 verbunden, so dass dort das elektrische Potenzial V+ anliegt. Der nicht-invertierende Eingang ist über einen Widerstand R7 mit dem Punkt 110 verbunden, an dem ein Referenzpotenzial Vref vorliegt.

Ferner ist der Ausgang des Komparators CP1 über einen Widerstand R8 auf den nicht-invertierenden Eingang rückgekoppelt. Hierdurch wird eine Mitkopplung erreicht, die zu einer Schalthysterese führt. Die Schalthysterese wird durch die Widerstände R7 und R8 bestimmt und verhindert ein fortwährendes Umschwingen des Komparators CP1, wenn das Potenzial V+ mit geringen Ausschlägen um den Wert des Referenzpotenzials Vref pendelt.

Der invertierende Eingang des zweiten Komparators CP2 ist mit dem Punkt 112 verbunden, an dem gleichfalls das Referenzpotenzial Vref vorliegt. Der nicht-invertierende Eingang ist mit dem Abgriff 108 des Spannungsteilers 104 verbunden, an dem das elektrische Potenzial V- vorliegt.

Eine Mitkopplung wird dadurch erreicht, dass der Ausgang des Komparators CP2 über einen Widerstand R9 auf den nicht-invertierenden Eingang rückgekoppelt ist. Hierdurch ergibt sich auch bei dem Komparator CP2 eine Schalthysterese, die durch den Widerstand R9 bestimmt wird. Die Schalthysterese verhindert, dass der Komparatoren CP2 fortwährend umschwingt, wenn das Potenzial V- mit geringen Ausschlägen um den Wert des Referenzpotenzials Vref pendelt.

Grundsätzlich kann auf die Schalthysterese bei dem Komparator CP1 und/oder bei dem Komparator CP2 verzichtet werden, ohne das Funktionsprinzip der Überwachungsschaltung 100 als solches zu beeinträchtigen. Bei dem Komparator CP1 fällt der Rückkopplungszweig mit dem Widerstand R8 weg, wenn auf die Hysterese verzichtet wird. Zudem kann auf den Widerstand R7 verzichtet und eine direkte Verbindung zwischen dem nicht-invertierenden Eingang des Komparators CP1 und dem Punkt 110 vorgesehen werden. Bei dem Komparator CP2 fällt der Rückkopplungszweig mit dem Widerstand R9 weg, wenn keine Hysterese gewünscht ist.

Das Referenzpotenzial Vref wird in der dargestellten Ausführungsform der Überwachungsschaltung 100 mittels einer möglichst genauen Zenerdiode D1 aus einer Versorgungsspannung Vs abgeleitet. In einfacher Weise wird hierdurch sichergestellt, dass das Referenzpotenzial Vref auch bei schwankender Versorgungsspannung Vs mit hoher Genauigkeit auf einen vorgegebenen Wert eingestellt werden kann. Das bedeutet, dass die Versorgungsspannung Vs Schwankungen unterworfen sein kann, ohne die Funktionen oder Zuverlässigkeit der Überwachungsschaltung 100 zu beeinträchtigen.

Die Versorgungsspannung Vs liegt über einer Reihenschaltung aus der Zenerdiode D1 und einem Widerstand R10 an, wobei die Zenerdiode D1 zwischen den Widerstand R10 und Massepotenzial geschaltet ist. Das an den Punkten 110 und 112 zwischen der Zenerdiode D1 und dem Widerstand R10 vorliegende Referenzpotenzial Vref entspricht somit der über der Zenerdiode D1 abfallenden Spannung.

Ohne Berücksichtigung der Schalthysterese ist der Ausgang des Komparators CP1 auf "high" geschaltet, solange das Potenzial V+ kleiner als das Referenzpotenzial Vref ist. Der Komparator CP1 schaltet den Ausgang auf "low", wenn das Potenzial V+ den Wert des Referenzpotenzials Vref überschreitet. Dies ist der Fall, wenn die zu überwachende Spannung Vdd den Wert

$$Vdd, H = \left(1 + \frac{R1}{R2}\right) \cdot Vref \qquad (1)$$

überschreitet. Berücksichtigt man die Hysterese, dann ergibt sich ein abweichender, höherer Wert, der auch von den Widerständen R7 und R8 abhängt. Die Abweichung und damit auch die Schalthysterese ist desto geringer, je kleiner das Verhältnis R7/R8 der Widerstand R7 und R8 ist.

Am Ausgang des Komparators CP2 liegt ohne Berücksichtigung der Schalthysterese der Zustand "high" vor, solange das Potenzial V- größer als das Referenzpotenzial Vref ist. Der Ausgang des Komparators CP2 schaltet in den Zustand "low" um, wenn das Potenzial V- den Wert des Referenzpotenzials Vref unterschreitet. Man berechnet, dass dies der Fall ist, wenn die zu überwachende Spannung Vdd den Wert

$$Vdd, L = \left(1 + \frac{R4}{R5}\right) \cdot Vref \qquad\qquad (2)$$

unterschreitet. Berücksichtigt man die Hysterese, ist der zu unterschreitende Wert geringer und hängt zusätzlich von dem Widerstand R9 ab. Je größer der Widerstand R9 ist, desto geringer ist dabei die Abweichung von dem in Gleichung (2) angegebenen Wert Vdd,L und damit auch die Schalthysterese.

Bei der dargestellten Schaltung sind die Ausgänge der beiden Komparatoren CP1, CP2 auf "high" geschaltet, solange die zu überwachende Spannung Vdd zwischen den Werten Vdd,L und Vdd,H liegt. Diese entsprechen den vorgesehenen Grenzwerten der Spannung Vdd und werden durch eine geeignete Wahl der Widerstände R1, R2, R4, R5 sowie des Referenzpotenzials Vref eingestellt. Vdd,L ist dabei der untere Grenzwert und Vdd,H der obere. Liegt eine Fehlspannung vor, dann schaltet einer der Komparatoren CP1, CP2 den Ausgang auf "low". Im Falle einer Überspannung ist dies der Komparator CP1 und bei Unterspannung der Komparator CP2.

Werden die Ausgänge der Komparatoren CP1, CP2 durch eine ODER-Schaltung miteinander verknüpft, dann kann am Ausgang dieser Schaltung eine Fehlspannung festgestellt werden.

Bei der in Figur 1 dargestellten Schaltung ist hierzu eine Open-Collector-Schaltung 114 vorgesehen, in der so genannte Open-Collector-Ausgänge der Komparatoren CP1, CP2 genutzt werden. Im Zustand "low" sind diese Ausgänge mit Massepotenzial verbunden, im Zustand "high" ist die Verbindung zum Massepotenzial unterbrochen. In der Open-Collector-Schaltung sind die Ausgänge der Komparatoren CP1, CP2 über einen Pull-Up-Widerstand mit einem Potenzial Vt verbunden. Dieses ist vorzugsweise positiv und kann beispielsweise der zu überwachenden Spannung Vdd oder der Versorgungsspannung Vs entsprechen, so dass keine weitere Spannung erzeugt werden muss. Gleichfalls könnte hier jedoch auch ein anderes Potenzial vorgesehen sein. Ferner sind die Ausgänge der Komparatoren CP1, CP2 mit dem Ausgang 116 der Überwachungsschaltung 100 verbunden. Zwischen dem Ausgang 116 der Überwachungsschaltung 100 und Massepotenzial kann eine Ausgangsspannung Ua der Überwachungsschaltung 100 erfasst werden.

Wenn die zu überwachende Spannung Vdd zwischen den Grenzwerten Vdd,L und Vdd,H liegt, dann ist die Ausgangsspannung Ua von null verschieden. Insbesondere ist die Ausgangsspannung Ua im Zustand "high", in dem am Ausgang der Überwachungsschaltung 100 ein positives elektrisches Potenzial vorliegt. Sobald eine Fehlspannung vorliegt und einer der Komparatoren CP1, CP2 den Ausgang 109, 113 auf "low" schaltet, nimmt die Ausgangsspannung Ua Zustand "low" an, in dem der Ausgang 116 der Überwachungsschaltung in der dargestellten Ausgestaltung auf Massepotenzial liegt. Durch die Ausgangsspannung Ua kann daher beispielsweise ein Sicherheitsmechanismus gesteuert werden, der im Falle einer Fehlspannung eingreift.

Die dargestellte Überwachungsschaltung 100 kann in einem Testmodus betrieben werden, um Störungen festzustellen. Im Testmodus kann ein Widerstand des Spannungsteilers 102 derart verändert werden, dass sich ein veränderter oberer Grenzwert Vdd,Htest ergibt, den die Spannung Vdd auch dann überschreitet, wenn keine Überspannung vorliegt. Hierzu wird zweckmäßigerweise ein mit hohem elektrischen Potenzial verbundener Widerstand des Spannungsteilers 102, der im normalen Betrieb der Überwachungsschaltung 100 durch den Widerstand R1 gebildet wird, vergrößert. Hierdurch wird erreicht, dass sich das Potenzial V+ am Punkt 106 vergrößert.

Gleichermaßen kann ein Widerstand des Spannungsteilers 104 so verändert werden, dass sich ein veränderter unterer Grenzwert Vdd,Ltest ergibt, den die Spannung Vdd auch dann unterschreitet, wenn keine Unterspannung vorliegt. Hierzu wird zweckmäßigerweise ein mit niedrigem elektrischen Potenzial verbundener Widerstand des Spannungsteilers 104, der im normalen Betrieb der Überwachungsschaltung 100 durch den Widerstand R5 gebildet wird, vergrößert. Hierdurch wird erreicht, dass sich das Potenzial V- am Punkt 108 verringert.

Mit den veränderten Grenzwerten Vdd,Htest und Vdd,Ltest werden Fehlspannungen simuliert, um zu prüfen, ob diese von der Schaltung gemeldet werden. Ist dies jeweils der Fall, kann davon ausgegangen werden, dass die Schaltung einwandfrei funktioniert.

Zur Veränderung eines Widerstandes des Spannungsteilers 102 ist ein Strompfad 118 parallel zu dem Widerstand R1 geschaltet. Der Strompfad 118 umfasst die Reihenschaltung eines Widerstands R3 und eines steuerbaren Schaltelements T1, mit dem der Strompfad 118 geschlossen werden kann. Das Schaltelement T1 wird von einem Mikrocontroller μC gesteuert. In der dargestellten Ausführungsform handelt es sich bei dem Schaltelement T1 um einen Transistor, dessen Steueranschluss dem Basisanschluss entspricht, der über einen Vorwiderstand R12 angesteuert wird. Alternativ können jedoch auch andere dem Fachmann bekannte steuerbare Schaltelemente eingesetzt werden.

Zur Simulation einer Überspannung schließt der Mikrocontroller μC den Strompfad 118 mittels des Schaltelements T1, wodurch sich das elektrische Potenzial V+ an dem Punkt 106 verändert. Ohne Berücksichtigung der Schalthysterese des Komparators CP1 und bei Vernachlässigung des Spannungsabfalls über dem Schaltelement T1 ergibt sich hierdurch der veränderte obere Grenzwert

$$Vdd, Htest = \left(1 + \frac{R1 \cdot R3}{R2 \cdot (R1 + R3)}\right) \cdot Vref = Vdd, H - \frac{R1^2}{R2 \cdot (R1 + R3)} \cdot Vref \qquad (3)$$

der kleiner als Vdd,H ist und im Folgenden auch als obere Testschwelle bezeichnet wird. Der Widerstand R3 wird so dimensioniert, dass die Spannung Vdd die obere Testschwelle Vdd,Htest auch dann überschreitet, wenn sie sich innerhalb des erlaubten Bereichs, d.h, zwischen dem oberen Grenzwert Vdd,H und dem unteren Grenzwert Vdd,L, befindet.

Parallel zu dem Widerstand R5 des Spannungsteilers 104 ist ein Strompfad 120 geschaltet, der eine Reihenschaltung eines Widerstands R6 und eines steuerbaren Schaltelements T2 umfasst. Das Schaltelement T2 wird ebenfalls von dem Mikrocontroller µC gesteuert und ist in der dargestellten Ausführungsform als Transistor mit einem als Basis ausgestalteten Steueranschluss dargestellt. Die Ansteuerung erfolgt bei der dargestellten Ausgestaltung über einen Vorwiderstand R13. Selbstverständlich können jedoch anstelle eines Transistors auch andere dem Fachmann bekannte Schaltelemente verwendet werden.

Zur Simulation einer Unterspannung wird das Schaltelement T2 von dem Mikrocontroller µC geschlossen, so dass der Widerstand R6 parallel zu dem Widerstand R5 des Spannungsteilers 104 geschaltet wird und sich das elektrische Potenzial V- am Punkt 108 verändert. Ohne Berücksichtigung der Schalthysterese des Komparators CP2 und bei Vernachlässigung des Spannungsabfalls über dem Schaltelement T2 ergibt sich hierdurch der veränderte untere Grenzwert

$$Vdd, Ltest = \left(1 + \frac{R4}{R5} + \frac{R4}{R6}\right) \cdot Vref = Vdd, L + \frac{R4}{R6} \cdot Vref \qquad (4)$$

der größer als Vdd,L ist und im Folgenden auch als untere Testschwelle bezeichnet wird. Der Widerstand R6 wird dabei so dimensioniert, dass die Spannung Vdd die untere Testschwelle Vdd,Ltest auch dann unterschreitet, wenn sie sich innerhalb des erlaubten Bereichs befinden.

In der dargestellten Ausgestaltung werden somit die Widerstände in den Spannungsteilern 102 und 104 durch die Parallelschaltung von Strompfaden 118 und 120 zu Widerständen R1 und R5 verändert, um Fehlspannungen zu simulieren. In einem weiteren Beispiel, das nicht ein Teil der Erfindung ist, vorgesehen sein, dass die Spannungsteiler 102, 104 jeweils wenigstens drei Widerstände umfassen, wobei wenigstens ein Widerstand mittels eines Schaltelements überbrückt werden kann. Hierdurch wird der entsprechende Widerstand verringert und der Widerstand innerhalb des Spannungsteilers mithin geändert.

Überspannung und Unterspannung werden in einer Ausführungsform nacheinander simuliert. Ausgehend vom normalen Betrieb der Schaltung wird dabei zunächst eine Art der Fehlspannung simuliert und nachfolgend die andere, wobei jeweils geprüft wird, ob die Schaltung eine Fehlspannung meldet.

Hierbei wird die obere Testschwelle Vdd,Htest durch eine geeignete Dimensionierung des Widerstands R3 vorzugsweise so eingestellt, dass sie in etwa den Wert des unteren Grenzwerts Vdd,L hat. Insbesondere kann die obere Test. schwelle Vdd,Htest so eingestellt werden, dass sie nicht größer als der untere Grenzwert Vdd,L ist und vorzugsweise knapp unter dem unteren Grenzwert Vdd,L liegt. Hierdurch wird sichergestellt, dass der Ausgang des für die Überwachung des oberen Grenzwerts vorgesehenen Komparators CP1 auf "low" schaltet, wenn vor der Simulation keine Fehlspannung gemeldet wurde. In diesem Fall ist die Spannung Vdd nämlich größer als der untere Grenzwert Vdd,L, sofern die Schaltung störungsfrei arbeitet.

Analog wird die untere Testschwelle Vdd,Ltest durch eine geeignete Dimensionierung des Widerstands R6 so eingestellt, dass sie in etwa dem oberen Grenzwert Vdd,H entspricht. Insbesondere kann die untere Testschwelle Vdd,Ltest so eingestellt werden, dass sie nicht kleiner als der obere Grenzwert Vdd,H ist und vorzugsweise knapp über dem oberen Grenzwert Vdd,H liegt. Bei einer derartigen Wahl der Testschwelle Vdd,Ltest wird gewährleistet, dass der Ausgang des für die Überwachung des unteren Grenzwerts vorgesehenen Komparators CP2 auf "low" schaltet, wenn vor der Simulation keine Fehlspannung detektiert worden ist. Sofern die Schaltung keine Störung aufweist, ist die Spannung Vdd in diesem Fall nämlich kleiner als der oberer Grenzwert Vdd,H.

Gleichfalls kann es vorgesehen sein, den Fehlerfall dadurch zu simulieren, dass gleichzeitig beide Schaltelemente T1 und T2 geschlossen werden. Dies entspricht einer zeitgleichen Simulation einer Über- und Unterspannung. Die Testschwellen Vdd,Htest und Vdd,Ltest können in diesem Fall in etwa den gleichen Wert aufweisen, wobei die obere Testschwelle Vdd,Htest nicht größer sein sollte als die untere Testschwelle Vdd,Ltest, so dass sichergestellt ist, dass die Spannung Vdd entweder größer als die obere Testschwelle Vdd,Htest oder kleiner als die untere Testschwelle Vdd,Ltest ist und der Ausgang eines der Komparatoren CP1, CP2 auf "low" schaltet, sofern die Schaltung nicht gestört ist. Insbesondere kann eine gleichzeitige Simulation einer Über- und Unterspannung dann vorgenommen werden, wenn die Ausgänge der Komparatoren CP1, CP2 unabhängig voneinander überwacht werden, was in einer alternativen Ausgestaltung der Schaltungsanordnung, die in den Figuren nicht dargestellt ist, ebenfalls möglich ist.

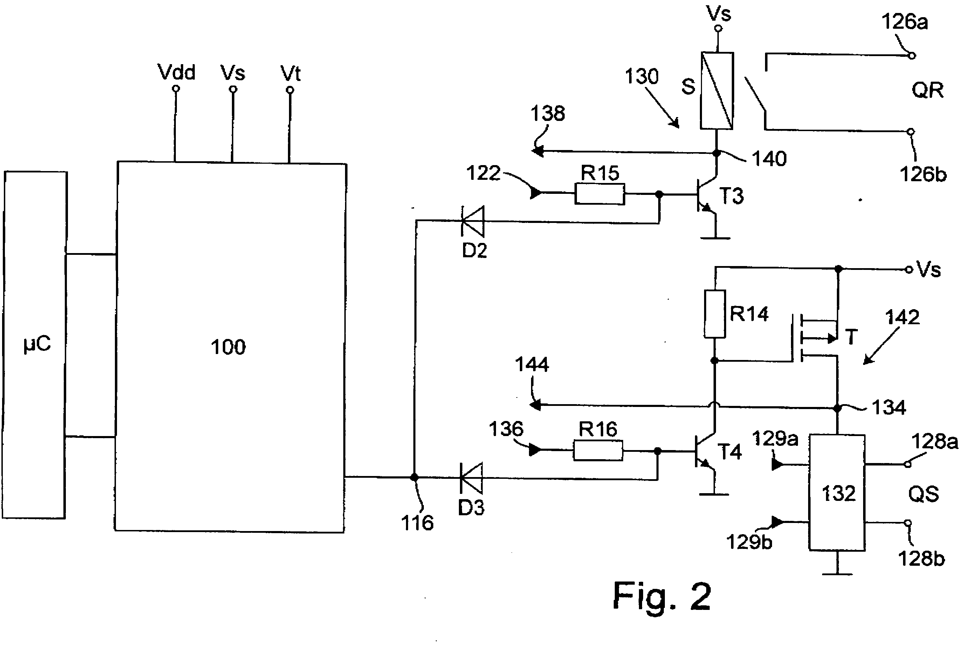

Figur 2 veranschaulicht den Einsatz der zuvor beschriebenen Überwachungsschaltung 100 in einem Steuergerät mit sicheren Ausgängen QR und QS und zur Steuerung von Anlagen oder Geräten, wie beispielsweise Motoren. Die Ausgänge werden von einem oder mehreren Mikrocontrollern gesteuert, um Steuerungsaufgaben auszuführen. Bei einem der Mikrocontroller kann es sich um den für die Simulation von Fehlspannungen vorgesehenen Mikrocontroller μC handeln. Zusätzlich können weitere Mikrocontroller vorgesehen sein, die in der Figur nicht dargestellt sind. Bei der zu überwachenden Spannung Vdd kann es sich beispielsweise um die Versorgungsspannung der in dem Steuergerät enthaltenen Mikrocontroller handeln. Üblicherweise muss diese bei Mikrocontrollern z.B. zwischen 4,5 V und 5,5 V liegen, um eine einwandfreie Funktion der Mikrocontroller zu gewährleisten.

Die Anschlüsse 126a und 126b des Ausgangs QR können an einen Lastkreis angeschlossen werden, der mittels eines Relais S gesteuert, insbesondere ein- und abgeschaltet werden kann. Das Relais S wird durch ein steuerbares Schaltelement T3 gesteuert, das innerhalb eines Steuerstromkreises 130 in Reihe mit dem Relais S geschaltet ist, wobei über der Reihenschaltung die Versorgungsspannung Vs des Steuergeräts anliegt. Bei dem Schaltelement T3 handelt es sich in der dargestellten Ausgestaltung wiederum um einen Transistor. Andere dem Fachmann bekannte steuerbare Schaltelemente können jedoch gleichfalls eingesetzt werden.

Solange das Schaltelement T3 eingeschaltet ist, fließt ein Strom durch das Relais S, so dass der Lastkreis am Ausgang QR geschlossen ist. Beim Abschalten des Schaltelements T3 wird der durch das Relais S fließende Steuerstrom unterbrochen, so dass das Relais S abgeschaltet wird. Hierdurch wird der Ausgang QR abgeschaltet, das heißt, der Lastkreis unterbrochen. Das Schaltelement T3 kann über einen Vorwiderstand R15 mit einem Steuersignal beaufschlagt werden, das über einen Anschluss 122 bereitgestellt wird. Dieser ist mit den Mikrocontrollern des Steuergeräts verbunden, um die vorgesehenen Steuerungsaufgaben durchzuführen.

Der Ausgang QS wird mittels eines Ausgangstreibers 132 gesteuert, der in der dargestellten Ausgestaltung zwei Ausgangsanschlüsse 128a, 128b aufweist. Im allgemeinen kann eine beliebige Anzahl von Ausgangsanschlüssen vorgesehen werden; üblich sind insbesondere vier Ausgangsanschlüsse. Der Ausgangstreiber 132 wird über Steueranschlüsse 129a,b von den Mikrocontrollern des Steuergeräts gesteuert, um die vorgesehenen Steuerungsaufgaben auszuführen. Die Energieversorgung des Ausgangstreibers 132 wird über den Versorgungskreis 142 bereitgestellt wird. Der Versorgungskreis 142 umfasst einen Versorgungstransistor T, bei dem es sich beispielsweise um einen MOSFET handelt. Über den Versorgungstransistor T wird dem Ausgangstreiber 132 eine Versorgungsspannung zugeführt, bei der es sich ebenfalls um die Versorgungsspannung Vs des Steuergeräts handeln kann. Wenn der Versorgungstransistor T abgeschaltet wird, dann wird die Spannungsversorgung des Ausgangstreibers 132 unterbrochen und der Ausgang QS abgeschaltet. Der Versorgungstransistor T wird durch ein Schaltelement T4 gesteuert, wobei der Anschluss des Versorgungstransistors T, das heißt, bei Verwendung eines MOSFETS dessen Gateanschluss, über einen Widerstand R14 mit der Versorgungsspannung Vs und über das Schaltelement T4 mit Massepotenzial verbunden ist. Das Schaltelement T4 ist in der dargestellten Ausgestaltung wiederum als Transistor ausgeführt; andere dem Fachmann bekannte steuerbare Schaltelemente können jedoch gleichermaßen verwendet werden.

Bei dem Versorgungstransistor T handelt es sich in der dargestellten Ausgestaltung um einen p-Kanal-MOSFET. Solange das Schaltelement T4 eingeschaltet ist, besteht eine Spannung zwischen dem Gateanschluss und dem Sourcekontakt, so dass der Versorgungstransistor T eingeschaltet ist. Im eingeschalteten Zustand wird der Ausgangstreiber 132 über den Versorgungstransistor T mit Energie versorgt. Sobald das Schaltelement T4 ausgeschaltet wird, sinkt die Spannung zwischen dem Gateanschluss und dem Sourcekontakt, und der Versorgungstransistor T geht in den Sperrzustand über. Hierdurch wird die Spannungsversorgung des Ausgangstreibers 132 unterbrochen, so dass der Ausgang QS bzw. die Ausgangsanschlüsse 128a,b abgeschaltet werden.Wie das Schaltelement T3 kann das Schaltelement T4 über einen Vorwiderstand R16 mit einem Steuersignal beaufschlagt werden, das über einen Anschluss 136 bereitgestellt wird, der mit den Mikrocontrollern des Steuergeräts verbunden ist, um den Ausgang QS zu schalten.

Überschreitet die zu überwachende Spannung Vdd den vorgegebenen oberen Grenzwert oder unterschreitet sie den vorgegebenen unteren Grenzwert, dann werden die Ausgänge QR und QS abgeschaltet. Um dies zu erreichen, sind die Steueranschlüsse der Schaltelemente T3 und T4 über eine Ausgangsstufe mit dem Ausgang 116 der in Figur 1 dargestellten Überwachungsschaltung 100 verbunden. Über die Ausgangsstufe werden die Schaltelemente T3 und T4 abgeschaltet, wenn eine Fehlspannung vorliegt, das heißt, wenn der Ausgang 116 der Überwachungsschaltung 100 auf "low" geschaltet ist. Wenn der Ausgang 116 der Überwachungsschaltung 100 auf "high" geschaltet ist, dann erfolgt keine Beeinflussung der Ansteuerung der Schaltelemente T3 und T4.

Beispielhaft ist in Figur 2 eine Ausgangsstufe dargestellt, welche Dioden D2 und D3 umfasst, über die die Steueranschlüsse der Schaltelemente T3 und T4 mit dem Ausgang 116 der Überwachungsschaltung 100 verbunden sind. Durch eine geeignete Polung der Dioden D2, D3 wird dabei erreicht, dass die Dioden D2, D3 in den leitenden Zustand übergehen, wenn am Ausgang 116 der Überwachungsschaltung 100 der Zustand "low" vorliegt, und dass sich die Dioden D2, D3 im Sperrzustand befinden, wenn am Ausgang 116 der Überwachungsschaltung 100 der Zustand "high" vorliegt. Ist der Ausgang 116 der Überwachungsschaltung 100 auf "low" geschaltet, werden die Steueranschlüsse der Schaltelemente T3 und T4 somit auf ein niedriges Potenzial, insbesondere auf Massepotenzial, gelegt, so dass die Schaltelemente T3 und T4 abgeschaltet werden. Vorzugsweise sind die Diodenvorwärtsspannungen dabei klein genug, so dass die Schaltelemente T3 und T4 sicher abgeschaltet werden können.

Alternativ zu der dargestellten Ausführungsform kann die Ausgangsstufe auch in anderer Weise, insbesondere mithilfe von Transistoren, aufgebaut werden, um die zuvor beschriebene Funktion auszuführen.

Zwischen dem Versorgungstransistor T und dem Ausgangstreiber 132 ist ein Abgriff 134 zum Erfassen der Steuerspannung des Ausgangstreibers 132 vorgesehen. Ober einen Anschluss 144 ist der Mikrocontroller µC mit dem Abgriff 134 verbunden und misst während der Simulation eines Fehlers der zu überwachenden Spannung Vdd die Steuerspannung des Ausgangstreibers 132. Dabei prüft der Mikrocontroller µC, ob die Spannungsversorgung des Ausgangstreibers 132 während der Simulation einer Überspannung und während der Simulation einer Unterspannung unterbrochen wird. Ist dies der Fall, dann arbeitet die Überwachungsschaltung 100 einwandfrei. Wird die Spannungsversorgung des Ausgangstreibers 132 jedoch nicht unterbrochen, dann stellt der Mikrocontroller µC eine Störung der Überwachungsschaltung 100 fest.

Der Ausgangstreiber 132 schaltet den Ausgang QS während der Simulation einer Fehlspannung ab. Alternativ oder zusätzlich kann es daher auch vorgesehen sein, dass während der Simulation einer Fehlspannung von dem Mikrocontroller µC geprüft wird, ob der Lastkreis am Ausgang QS unterbrochen wird. Eine Störung der Überwachungsschaltung 100 wird bei dieser Ausgestaltung festgestellt, wenn während der Simulation einer Fehlspannung keine Unterbrechung des Lastkreises erkannt wird.

Darüber hinaus ist mittels des Mikrocontrollers µC der Steuerstrom durch das Relais S während einer Simulation eines Fehlers der zu überwachenden Spannung Vdd erfassbar. Wird dieser während der Simulation einer Fehlspannung unterbrochen, dann arbeitet die Überwachungsschaltung 100 störungsfrei. Wird jedoch keine Unterbrechung des Steuerstroms festgestellt, dann erkennt der Mikrocontroller µC eine Störung der Überwachungsschaltung 100. Die Erfassung des Steuerstroms des Relais erfolgt mittels einer Strommessschaltung, die in Figur 2 anhand des Abgriffs 140 und des Anschlusses 138 schematisch veranschaulicht ist. Die tatsächliche Strommessschaltung kann in einer dem Fachmann bekannten Weise realisiert werden.

In einer alternativen Ausgestaltung kann anstelle einer Strommessung auch eine Spannungsmessung vorgesehen sein, um eine Unterbrechung der Energieversorgung des Relais zu ermitteln. Gleichfalls kann in einer in den Figuren nicht dargestellten Ausgestaltung auch bei dem Relaisausgang QR vorgesehen sein, dass ein Versorgungstransistor zum Zwecke der Spannungsunterbrechung verwendet wird. In diesem Fall kann die Unterbrechung des Steuerstroms analog wie bei dem Transistorausgang QS ermittelt werden.

Die Simulation einer Fehlspannung wird vorzugsweise periodisch vorgenommen, um die korrekte Funktion der Überwachungsschaltung 100 fortwährend zu überwachen. Die Dauer der Simulation ist vorgegeben und wird vorzugsweise nicht größer als 1 ms gewählt.

Aufgrund der kurzen Dauer führt die Abschaltung des Ausgangs QS während der Simulation nicht zur Unterbrechung von Geräten in dem entsprechenden Lastkreis. Das Relais S folgt der kurzen Unterbrechung des Steuerstroms während der Simulation aufgrund seins langsameren Ansprechverhaltens nicht, so dass der Lastkreis am Ausgang QR nicht unterbrochen wird.

Obwohl die Erfindung in den Zeichnungen und der vorausgegangenen Darstellung im Detail beschrieben wurde, sind die Darstellungen illustrativ bzw. beispielhaft und nicht einschränkend zu verstehen; insbesondere ist die Erfindung nicht auf die erläuterten Ausführungsbeispiele beschränkt.

Weitere Varianten der Erfindung und ihre Ausführung ergeben sich für den Fachmann aus der vorangegangenen Offenbarung, den Figuren und den Patentansprüchen. In den Patentansprüchen verwendete Begriffe wie "umfassen", "aufweisen", "beinhalten", "enthalten" und dergleichen schließen weitere Elemente oder Schritte nicht aus. Die Verwendung des unbestimmten Artikels schließt eine Mehrzahl nicht aus. Eine einzelne Einrichtung kann die Funktionen mehrerer in den Patentansprüchen genannten Einheiten beziehungsweise Einrichtungen ausführen.

**Patentansprüche**

1. Schaltungsanordnung zum Überwachen einer Spannung (Vdd), umfassend eine Komparatorschaltung (CP1, CP2) nach Art eines Fensterkomparators, mit der zwei von der zu überwachenden Spannung (Vdd) abgeleitete Potenziale (V+; V-) mit einem Referenzpotenzial (Vref) vergleichbar sind, um zu überwachen, ob die zu überwachende Spannung (Vdd) zwischen einem unteren und oberen Grenzwert (Vdd,L; Vdd,H) liegt und eine Fehlspannung festzustellen, **dadurch gekennzeichnet, dass** die Schaltungasanordnung zwei Spannungsteiler umfasst, wobei die von der zu überwachenden Spannung (Vdd) abgeleiteten Potenziale (V+; V-) jeweils an einem von den zwei Spannungsteilern (102; 104) abgegriffen werden, wobei die zwei Spannungsteiler (102; 104) parallel geschaltet sind und jeder der zwei Spannungsteiler (102; 104) eine Reihenschaltung aus wenigstens zwei Widerständen (R1, R2; R4, R5) umfasst, wobei ein Widerstand innerhalb jedes der zwei Spannungsteiler (102; 104) derart veränderbar ist, dass sich ein veränderter oberer Grenzwert (Vdd,Htest) ergibt, den die zu überwachende Spannung (Vdd) auch dann überschreitet, wenn keine Überspannung über dem oberen Grenzwert (Vdd,H) vorliegt, und sich ein veränderter unterer Grenzwert (Vdd,Ltest) ergibt, den die zu überwachende Spannung (Vdd) auch dann unterschreitet, wenn keine Unterspannung unter dem unteren Grenzwert (Vdd,L) vorliegt und dadurch eine Fehlspannung simuliert werden kann, und wobei der Widerstand innerhalb jedes der zwei Spannungsteiler (102; 104) dadurch veränderbar ist, dass ein elektrisch parallel zu einem Widerstand (R1; R5) des jeweiligen Spannungsteilers (102; 104) geschalteter Strompfad (118; 120), der einen weiteren Widerstand (R3; R6) umfasst, durch ein Schaltelement (T1; T2) geschlossen wird.

2. Schaltungsanordnung nach einem der vorangegangenen Ansprüche, wobei ein unteres von der zu überwachenden Spannung (Vdd) abgeleitetes Potenzial (V-) an einem ersten der zwei Spannungsteiler (104) abgreifbar ist und mit dem Referenzpotenzial (Vref) vergleichbar ist, um zu prüfen, ob die Unterspannung vorliegt, bei der das untere Potenzial (V-) kleiner als das Referenzpotenzial (Vref) ist.

3. Schaltungsanordnung nach Anspruch 2, wobei der Widerstand des ersten Spannungsteilers (104) derart veränderbar ist, dass das untere Potenzial (V-) auch dann kleiner als das Referenzpotenzial (Vref) ist, wenn die zu überwachende Spannung (Vdd) zwischen dem unteren und oberen Grenzwert (Vdd,L; Vdd,H) liegt.

4. Schaltungsanordnung nach einem der vorangegangenen Ansprüche, wobei ein oberes von der zu überwachenden Spannung (Vdd) abgeleitetes Potenzial (V+) an einem zweiten der zwei Spannungsteiler (102) abgreifbar ist und mit dem Referenzpotenzial (Vref) vergleichbar ist, um zu prüfen, ob die Überspannung vorliegt, bei der das obere Potenzial (V+) größer als das Referenzpotenzial (Vref) ist.

5. Schaltungsanordnung nach Anspruch 4, wobei der Widerstand des zweiten Spannungsteilers (102) derart veränderbar ist, dass das obere Potenzial (V+) auch dann kleiner als das Referenzpotenzial (Vref) ist, wenn die zu überwachende Spannung (Vdd) zwischen dem unteren und oberen Grenzwert (Vdd,L; Vdd,H) liegt.

6. Steuergerät mit einem Steuerschaltelement (T3; T4) und einer Schaltungsanordnung nach einem der vorangegangenen Ansprüche, wobei im Falle einer Fehlspannung über einen Ausgang (116) der Komparatorschaltung das Steuerschaltelement (T3; T4) ansteuerbar ist, mit dem eine Energieversorgung zum Steuern eines Ausgangs (QR; QS) des Steuergeräts unterbrochen werden kann, und wobei ein Abgriff (140; 134) vorgesehen ist, an dem eine Unterbrechung der Energieversorgung bei Simulation einer Fehlspannung erfassbar ist.

7. Steuergerät mit einem ersten Steuerschaltelement (T3), einem Relais (S), einer Messeinrichtung und einer Schaltungsanordnung nach einem der Ansprüche 1-5, wobei im Falle einer Fehlspannung über einen Ausgang (116) der Komparatorschaltung das erste Steuerschaltelement (T3) in einem Steuerstromkreis (130) des Relais (S) abschaltbar ist, wobei mit dem Relais (S) ein erster Ausgang (QR) des Steuergeräts schaltbar ist, und wobei der Steuerstromkreis (130) mit der Messeinrichtung (138, 140, $\mu$C) verbunden ist, mit der ein Steuerstrom des Relais (S) bei Simulation einer Fehlspannung erfassbar ist.

8. Steuergerät nach Anspruch 7, wobei im Falle einer Fehlspannung über einen Ausgang (116) der Komparatorschaltung ein zweites Steuerschaltelement (T4) zur Ansteuerung eines Halbleiterschalters (T) abschaltbar ist, mit dem eine Versorgungsspannung zur Steuerung eines zweiten Ausgangs (QS) des Steuergeräts steuerbar ist, und wobei ein Abgriff (134) vorgesehen ist, an dem die Versorgungsspannung bei der Simulation einer Fehlspannung erfassbar ist.

9. Schaltungsanordnung nach einem der Ansprüche 1-5 und Steuergerät nach einem der Ansprüche 6-8, wobei die Komparatorschaltung zwei Komparatoren (CP1; CP2) umfasst, welche Open-Collector-Ausgänge aufweisen, welche in einer Open-Collector-Schaltung verknüpft sind, die eine Ausgangsspannung (Ua) der Komparatorschaltung erzeugt.

10. Verfahren zum Überprüfen einer Schaltungsanordnung mit einer Komparatorschaltung (CP1, CP2), mit der zwei von der zu überwachenden Spannung (Vdd) abgeleitete Potenziale (V+; V-) mit einem Referenzpotenzial (Vref) verglichen werden, um zu überwachen, ob die zu überwachende Spannung (Vdd) zwischen einem unteren und oberen Grenzwert (Vdd, L; Vdd,H) liegt und eine Fehlspannung festzustellen, **dadurch gekennzeichnet, dass** die von der zu überwachenden Spannung (Vdd) abgeleiteten Potenziale (V+; V-) jeweils an einem von zwei Spannungsteilern (102; 104) abgegriffen werden, wobei die zwei Spannungsteiler (102; 104) parallel geschaltet sind und jeder der zwei Spannungsteiler (102; 104) eine Reihenschaltung aus wenigstens zwei Widerständen (R1, R2; R4, R5) umfasst, wobei ein Widerstand innerhalb jedes der zwei Spannungsteiler (102; 104) derart verändert wird, dass sich ein veränderter oberer Grenzwert (Vdd,Htest) ergibt, den die zu überwachende Spannung (Vdd) auch dann überschreitet, wenn keine Überspannung über dem oberen Grenzwert (Vdd,H) vorliegt, und sich ein veränderter unterer Grenzwert (Vdd,Ltest) ergibt, den die zu überwachende Spannung (Vdd) auch dann unterschreitet, wenn keine Unterspannung unter dem unteren Grenzwert (Vdd,L) vorliegt, und dadurch eine Fehlspannung simuliert wird, und wobei der Widerstand innerhalb jedes der zwei Spannungsteiler (102; 104) dadurch verändert wird, indem ein elektrisch parallel zu einem Widerstand (R1; R5) des jeweiligen Spannungsteilers (102; 104) geschalteter Strompfad (118; 120), der einen weiteren Widerstand (R3; R6) umfasst, durch ein Schaltelement (T1; T2) geschlossen wird.

**Claims**

1. A circuit arrangement for monitoring a voltage (Vdd), comprising a comparator circuit (CP1, CP2) in the manner of a window comparator, with which two potentials (V+; V-) derived from the voltage (Vdd) to be monitored can be compared to a reference potential (Vref) in order to monitor whether the voltage (Vdd) to be monitored is between a lower and upper limit value (Vdd,L; Vdd,H) and to determine a false voltage, **characterized in that** the circuit arrangement comprises two voltage dividers, wherein the potentials (V+; V-) derived from the voltage (Vdd) to be monitored are each picked off at one of the two voltage dividers (102; 104), wherein the two voltage dividers (102; 104) are switched in parallel and each of the two voltage dividers (102; 104) comprises a series circuit of at least two resistors (R1, R2; R4, R5), wherein a resistance within each of the two voltage dividers (102;104) can be changed in such a way that a changed upper limit value (Vdd,Htest) results, which also exceeds the voltage (Vdd) to be monitored when no overvoltage above the upper limit value (Vdd,H) is present, and a changed lower limit value (Vdd,Ltest) results, which also falls below the voltage (Vdd) to be monitored when no undervoltage below the lower limit value (Vdd,L) is present and as a result a false voltage can be simulated, and wherein the resistance within each of the two voltage dividers (102; 104) can be changed in that a current path (118; 120) that is switched electrically parallel to a resistor (R1; R5) of the respective voltage divider (102; 104), which current path comprises a further resistor (R3; R6), is closed by a switching element (T1; T2).

2. Circuit arrangement according to any of the preceding claims, wherein a lower potential (V-) derived from the voltage (Vdd) to be monitored can be picked off at a first of the two voltage dividers (104) and can be compared to the reference potential (Vref) to check whether the undervoltage is present at which the lower potential (V-) is less than the reference potential (Vref).

3. Circuit arrangement according to Claim 2, wherein the resistance of the first voltage divider (104) can be changed such that the lower potential (V-) is also less than the reference potential (Vref) when the voltage (Vdd) to be monitored lies between the lower and upper limit values (Vdd,L; Vdd,H).

4. Circuit arrangement according to any one of the preceding claims, wherein an upper potential (V+) derived from the voltage (Vdd) to be monitored can be picked off at a second of the two voltage dividers (102) and can be compared to the reference potential (Vref) to check whether the overvoltage is present at which the upper potential (V+) is greater than the reference potential (Vref).

5. Circuit arrangement according to Claim 4, wherein the resistance of the second voltage divider (102) can be changed such that the upper potential (V+) is also less than the reference potential (Vref) when the voltage (Vdd) to be monitored is between the lower and upper limit values (Vdd,L; Vdd,H).

6. Control device comprising a control switching element (T3; T4) and a circuit arrangement according to any one of the preceding claims, wherein, in the event of a false voltage via an output (116) of the comparator circuit, the control switching element (T3; T4) can be actuated, with which an energy supply for controlling an output (QR; QS) of the control device can be interrupted, and wherein a tap (140; 134) is provided, at which an interruption of the energy supply can be detected during simulation of a false voltage.

7. Control device comprising a first control switching element (T3), a relay (S), a measuring device and a circuit arrangement according to any one of Claims 1 - 5, wherein, in the event of a false voltage via an output (116) of the comparator circuit, the first control switching element (T3) can be switched off in a control circuit (130) of the relay (S), wherein a first output (QR) of the control device can be switched with the relay (S), and wherein the control circuit (130) is connected to the measuring device (138, 140, μC), with which a control current of the relay (S) can be detected during simulation of a false voltage.

8. Control device according to Claim 7, wherein, in the event of a false voltage via an output (116) of the comparator circuit, a second control switching element (T4) can be switched off for actuating a semiconductor switch (T), with which a supply voltage for controlling a second output (QS) of the control device can be controlled, and wherein a tap (134) is provided, at which the supply voltage can be detected during the simulation of a false voltage.

9. Circuit arrangement according to any one of Claims 1 - 5 and control device according to any one of Claims 6 - 8, wherein the comparator circuit comprises two comparators (CP1; CP2) which have open collector outputs which are linked in an open collector circuit that generates an output voltage (Ua) of the comparator circuit.

10. Method for checking a circuit arrangement with a comparator circuit (CP1, CP2), with which two potentials (V+; V-) derived from the voltage (Vdd) to be monitored are compared to a reference potential (Vref) in order to monitor whether the voltage (Vdd) to be monitored is between a lower and upper limit value (Vdd,L; Vdd,H) and to determine a false voltage, **characterized in that** the potentials (V; V-) derived from the voltage (Vdd) to be monitored are each picked off at one of two voltage dividers (102; 104), wherein the two voltage dividers (102; 104) are connected in parallel and each of the two voltage dividers (102; 104) comprises a series circuit of at least two resistors (R1, R2; R4, R5), wherein a resistance within each of the two voltage dividers (102;104) can be changed such that a changed upper limit value (Vdd,Htest) results, which also exceeds the voltage (Vdd) to be monitored when no overvoltage above the upper limit value (Vdd,H) is present, and a changed lower limit value (Vdd,Ltest) results, which also falls below the voltage (Vdd) to be monitored when no undervoltage below the lower limit value (Vdd,L) is present, and as a result a false voltage is simulated, and wherein the resistance within each of the two voltage dividers (102; 104) is changed **in that** a current path (118; 120) that is switched electrically parallel to a resistor (R1; R5) of the respective voltage divider (102; 104), which current path comprises a further resistor (R3; R6), is closed by a switching element (T1; T2).

**Revendications**

1. Agencement de circuit pour surveiller une tension (Vdd), comprenant un circuit comparateur (CP1, CP2) de type comparateur à fenêtre, permettant de comparer deux potentiels (V+ ; V-) dérivés de la tension (Vdd) à surveiller à un potentiel de référence (Vref), afin de surveiller si la tension (Vdd) à surveiller se situe entre des valeurs limites inférieure et supérieure (Vdd,L ; Vdd,H) et d'identifier un défaut de tension, **caractérisé en ce que** l'agencement de circuit comprend deux diviseurs de tension, dans lequel les potentiels (V+ ; V-) dérivés de la tension (Vdd) à surveiller sont obtenus respectivement au niveau d'un des deux diviseurs de tension (102 ; 104), dans lequel les deux diviseurs de tension (102 ; 104) sont connectés en parallèle et chacun des deux diviseurs de tension (102 ; 104) comprend un circuit série constitué d'au moins deux résistances (R1, R2 ; R4, R5), dans lequel une résistance au sein de chacun des deux diviseurs de tension (102 ; 104) peut être modifiée de manière à produire une valeur limite supérieure (Vdd,Htest) modifiée, qui dépasse également la tension (Vdd) à surveiller, lorsqu'aucune surtension n'est présente au-dessus de la valeur limite supérieure (Vdd,H) et à produire une valeur limite inférieure (Vdd,Ltest) modifiée, inférieure également à la tension (Vdd) à surveiller lorsqu'aucune sous-tension n'est présente au-dessous de la valeur limite inférieure (Vdd,L) et par ce biais, un défaut de tension peut être simulé et dans lequel la résistance au sein de chacun des deux diviseurs de tension (102 ; 104) peut être modifiée **en ce qu'**un chemin de courant (118 ; 120), connecté électriquement en parallèle à une résistance (R1 ; R5) du diviseur de tension (102 ; 104) respectif, qui comprend une autre résistance (R3 ; R6), peut être fermé par un élément de commutation (T1 ; T2).

2. Agencement de circuit selon l'une quelconque des revendications précédentes, dans lequel un potentiel (V-) inférieur dérivé de la tension (Vdd) à surveiller peut être obtenu au niveau d'un premier des deux diviseurs de tension (104) et comparé au potentiel de référence (Vref), afin de vérifier si une sous-tension est présente, avec laquelle le potentiel inférieur (V-) est inférieur au potentiel de référence (Vref).

3. Agencement de circuit selon la revendication 2, dans lequel la résistance du premier diviseur de tension (104) peut être modifiée de sorte que le potentiel inférieur (V-) soit également inférieur au potentiel de référence (Vref) lorsque la tension (Vdd) à surveiller se situe entre les valeurs limites inférieure et supérieure (Vdd,L ; Vdd,H).

4. Agencement de circuit selon l'une quelconque des revendications précédentes, dans lequel un potentiel (V+) supérieur dérivé de la tension (Vdd) à surveiller peut être obtenu au niveau d'un second des deux diviseurs de tension (102) et comparé au potentiel de référence (Vref), afin de vérifier si une surtension est présente, avec laquelle le potentiel supérieur (V+) est supérieur au potentiel de référence (Vref).

5. Agencement de circuit selon la revendication 4, dans lequel la résistance du second diviseur de tension (102) peut être modifiée de sorte que le potentiel supérieur (V+) soit également inférieur au potentiel de référence (Vref) lorsque la tension (Vdd) à surveiller se situe entre les valeurs limites inférieure et supérieure (Vdd,L ; Vdd,H).

6. Appareil de commande comprenant un élément de commutation de commande (T3 ; T4) et un agencement de circuit selon l'une quelconque des revendications précédentes, dans lequel l'élément de commutation de commande (T3 ; T4) peut être commandé en cas de défaut de tension par le biais d'une sortie (116) du circuit comparateur, avec laquelle une alimentation en énergie pour commander une sortie (QR ; QS) de l'appareil de commande peut être interrompue et dans lequel une prise (140 ; 134) est prévue, au niveau de laquelle une interruption de l'alimentation en énergie peut être détectée lors de la simulation d'un défaut de tension.

7. Appareil de commande comprenant un premier élément de commutation de commande (T3), un relais (S), un dispositif de mesure et un agencement de circuit selon l'une quelconque des revendications 1 à 5, dans lequel le premier élément de commutation de commande (T3) peut être déconnecté dans un circuit de commande électrique (130) du relais (S) en cas de défaut de tension par le biais d'une sortie (116) du circuit comparateur, dans lequel une première sortie (QR) de l'appareil de commande peut être commutée avec le relais (S) et dans lequel le circuit de commande électrique (130) est relié au dispositif de mesure (138, 140, μC), avec lequel un courant de commande du relais (S) peut être détecté lors de la simulation d'un défaut de tension.

8. Appareil de commande selon la revendication 7, dans lequel un second élément de commutation de commande (T4) peut être déconnecté en cas de défaut de tension par le biais d'une sortie (116) du circuit comparateur pour la commande d'un commutateur à semi-conducteur (T), avec lequel une tension d'alimentation pour la commande d'une seconde sortie (QS) de l'appareil de commande peut être commandée et dans lequel une prise (134) est prévue, au niveau de laquelle la tension d'alimentation peut être détectée lors de la simulation d'un défaut de tension.

9. Agencement de circuit selon l'une quelconque des revendications 1 à 5 et appareil de commande selon l'une quelconque des revendications 6 à 8, dans lequel le circuit comparateur comprend deux comparateurs (CP1 ; CP2), qui présentent des sorties à collecteurs ouverts, qui sont reliées dans un circuit à collecteurs ouverts, qui produit une tension de sortie (Ua) du circuit comparateur.

10. Procédé pour surveiller un agencement de circuit comprenant un circuit comparateur (CP1, CP2), permettant de comparer deux potentiels (V+ ; V-) dérivés de la tension (Vdd) à surveiller à un potentiel de référence (Vref), afin de surveiller si la tension (Vdd) à surveiller se situe entre des valeurs limites inférieure et supérieure (Vdd,L ; Vdd,H) et d'identifier un défaut de tension, **caractérisé en ce que** les potentiels (V+ ; V-) dérivés de la tension (Vdd) à surveiller sont obtenus respectivement au niveau d'un de deux diviseurs de tension (102 ; 104), dans lequel les deux diviseurs de tension (102 ; 104) sont connectés en parallèle et chacun des deux diviseurs de tension (102 ; 104) comprend un circuit série constitué d'au moins deux résistances (R1, R2 ; R4, R5), dans lequel une résistance au sein de chacun des deux diviseurs de tension (102 ; 104) peut être modifiée de manière à produire une valeur limite supérieure (Vdd,Htest) modifiée, qui dépasse également la tension (Vdd) à surveiller, lorsqu'aucune surtension n'est présente au-dessus de la valeur limite supérieure (Vdd,H) et à produire une valeur limite inférieure (Vdd,Ltest) modifiée, inférieure également à la tension (Vdd) à surveiller lorsqu'aucune sous-tension n'est présente au-dessous de la valeur limite inférieure (Vdd,L) et par ce biais un défaut de tension peut être simulé et dans lequel la résistance au sein de chacun des deux diviseurs de tension (102 ; 104) peut être modifiée **en ce qu'**un chemin de courant (118 ; 120), connecté électriquement en parallèle à une résistance (R1 ; R5) du diviseur de tension (102 ; 104) respectif, qui comprend une autre résistance (R3 ; R6), peut être fermé par un élément de commutation (T1 ; T2).

Fig. 1

EP 2 117 094 B1

Fig. 2

EP 2 117 094 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1042679 A1
- DE 10127054 A1
- DE 10142011 A2
- DE 19927389 A1